# EUROPÄISCHE PATENTANMELDUNG

(11) **EP 0 913 904 A2**
(43) Veröffentlichungstag der Anmeldung: **06.05.1999**
(21) Anmeldenummer: 98811022.7
(22) Anmeldetag: 14.10.1998
(51) Int. Cl.: H02H 3/33, G01R 31/327

(54) **Verfahren zur Erhöhung der Zuverlässigkeit eines Fehlerstrom-Schutzschalters und Fehlerstrom-Schutzschalter zur Durchführung dieses Verfahrens**

(30) Priorität: 03.11.1997 DE 19748391
(71) Anmelder: CMC Carl Maier + Cie AG, 8200 Schaffhausen (CH)
(72) Erfinder: Meyer, Siegfried, 78244 Gottmadingen (DE); Mühle, Peter, 8200 Schaffhausen (CH); Schneider, Gerhard, 78176 Blumberg (DE); Schwarz, Willy, 8476 Unterstammheim (CH)
(74) Vertreter: Kaiser, Helmut

(57) **Zusammenfassung**

Das Verfahren dient der Erhöhung der Zuverlässigkeit eines Fehlerstrom-Schutzschalters.

Bei diesem Verfahren wird die Erregerspule eines Magnetauslösers des Schalters derart mit Prüfstrom beaufschlagt, dass ein Anker des Magnetauslösers abhebt und nachfolgend wieder angezogen wird. Das Abheben des Ankers wird durch ein Abhebesignal erfasst. Tritt bedingt durch einen Fehler das Abhebesignal nicht auf, so wird dies gemeldet.

Der Prüfstrom wird von einem einzigen mindestens zwei Abschnitte aufweisenden Prüfsignal gebildet. Im ersten Abschnitt weist der Prüfstrom die Form einer Wechselstrom-Halbwelle auf mit einer mehrfach höheren Stromamplitude als ein das Abheben des Ankers beim Auftreten eines Fehlerstroms bewirkender Ansprechstrom. Zugleich erzeugt der Prüfstrom im ersten Abschnitt einen Magnetfluss, welcher dem im Anker geführten Magnetfluss (φ₃₂) des Permanentmagneten entgegengesetzt gerichtet ist. In dem an den ersten Abschnitt anschliessenden zweiten Abschnitt weist der Prüfstrom umgekehrte Polarität wie im ersten Abschnitt auf.

## Beschreibung

### TECHNISCHES GEBIET

Bei der Erfindung wird ausgegangen von einem Verfahren nach dem Oberbegriff von Patentanspruch 1. Die Erfindung betrifft auch einen Fehlerstrom-Schutzschalter (Fl-Schalter) zur Durchführung dieses Verfahrens.

### STAND DER TECHNIK

Ein Verfahren der vorgenannten Art und ein dieses Verfahren ausführender Fl-Schalter sind im DE 195 29 474 C1 beschrieben. Bei diesem Verfahren werden von einer steuerbaren Konstantstromquelle periodisch eine Folge von Prüfimpulsen vorgegebener Länge und zunehmender Höhe in einen Summenstromwandler des Fl-Schalters eingespeist. Diese Impulse werden in eine Spule eines einen beweglichen Anker aufweisenden Magnetauslösers des Fl-Schalters übertragen. Die Spule des Auslösers wird auf das Auftreten eines Induktionssignals hin überwacht, welches beim Abheben des Ankers aus einer Endlage gebildet wird. Der beim Auftreten des Induktionssignals eingespeiste Konstantstrom wird gespeichert und mit einem der einwandfreien Arbeitsweise des Fl-Schalters zugeordneten Wert verglichen. Nach jedem der Prüfimpulse wird ein Rückholimpuls mit umgekehrten Vorzeichen in den Summenstromwandler eingespeist. Hierdurch wird verhindert, dass der Fl-Schalter bei einwandfreiem Zustand anspricht.

### DARSTELLUNG DER ERFINDUNG

Der Erfindung, wie sie in den Patentansprüchen definiert ist, liegt die Aufgabe zugrunde, ein Verfahren der eingangs genannten Art anzugeben, welches in einfacher Weise einen zuverlässigen Betrieb eines Fl-Schalters ermöglicht, und zugleich einen dieses Verfahren durchführenden Fl-Schalter zu schaffen, welcher sich durch den Einsatz vergleichsweise einfacher Mittel auszeichnet.

Beim Verfahren nach der Erfindung wird durch das direkte Einspeisen einer den Magnetauslöser stark übererregenden Wechselstrom-Halbwelle erreicht, dass eine wesentlich grössere Kraft auf den Anker wirkt als notwendig wäre, um den Anker beim Auftreten eines Fehlerstrom aus seiner durch das Aufliegen auf einem Joch des Magnetauslösers bestimmten Endlage abzuheben. In der Endlage kann der Anker aufgrund von Umgebungseinflüssen, wie dem Zusammenwirken von Staub, Feuchtigkeit und Temperatur, mehr oder weniger stark mit dem Joch verklebt sein. Das vom normalen Fehlerstrom gebildete und an den Magnetauslöser geführte Auslösesignal reicht dann nicht mehr aus, um den Fl-Schalter auszulösen. Durch die starke Übererregung des Magnetauslösers gelangen hingegen vergleichsweise grosse Kräfte an den Anker, lösen ihn entgegen den Adhäsionskräften vom Joch und machen ihn so für normale Fehlerströme wieder ansprechbereit, ohne dass der Schalter revidiert werden muss. Wird trotz dieser starken Übererregung kein Abheben des Ankers detektiert, so wird dies gemeldet und es kann dann der Fl-Schalter ausser Betrieb gesetzt werden.

Da eine solche Übererregung leicht realisiert werden kann, und da das Auftreten oder Nichtauftreten eines das Abheben des Ankers detektierenden Signals mit einfachen Mitteln zu erreichen ist, zeichnet sich der das Verfahren nach der Erfindung durchführende Fl-Schalter bei hohen Verfügbarkeit durch einfachen Aufbau und geringe Herstellkosten aus.

### KURZE BESCHREIBUNG DER ZEICHNUNGEN

Bevorzugte Ausführungsbeispiele der Erfindung und die damit erzielbaren weiteren Vorteile werden nachfolgend anhand von Zeichnungen näher erläutert. Hierbei zeigt:
- Fig. 1: ein Prinzipschaltbild eines F1-Schalters zur Durchführung des Verfahrens nach der Erfindung,
- Fig. 2: eine Ansicht eines vereinfacht dargestellten Magnetauslösers des Fl-Schalters gemäss Fig. 1,
- Fig. 3: fünf Diagramme, in denen jeweils der zeitliche Verlauf des Stroms eines bei der Ausführung des Verfahrens nach der Erfindung verwendbaren Prüfsignals, welches jeweils dem Magnetauslöser gemäss Fig.2 zugeführt wird, dargestellt ist,
- Fig. 4: ein Diagramm, in dem der Verlauf des Stroms I des Prüfsignals, des Magnetflusses Φ im magnetischen Kreis des Magnetauslösers, einer durch den Magnetfluss hervorgerufenen und auf einen Anker des Magnetauslösers wirkenden Kraft K und einer Kraft F einer auf den Anker wirkenden Feder in Abhängigkeit von der Zeit t dargestellt sind,
- Fig. 5: ein Blockschaltbild einer ersten Ausführungsform des Fl-Schalters gemäss Fig. 1,
- Fig. 6: ein Blockschaltbild einer zweiten Ausführungsform des Fl-Schalters gemäss Fig. 1,
- Fig. 7: ein Blockschaltbild einer dritten Ausführungsform des Fl-Schalters gemäss Fig.1, und
- Fig. 8: ein Blockschaltbild einer vierten Ausführungsform des Fl-Schalters gemäss Fig.1.

### WEG ZUR AUSFÜHRUNG DER ERFINDUNG

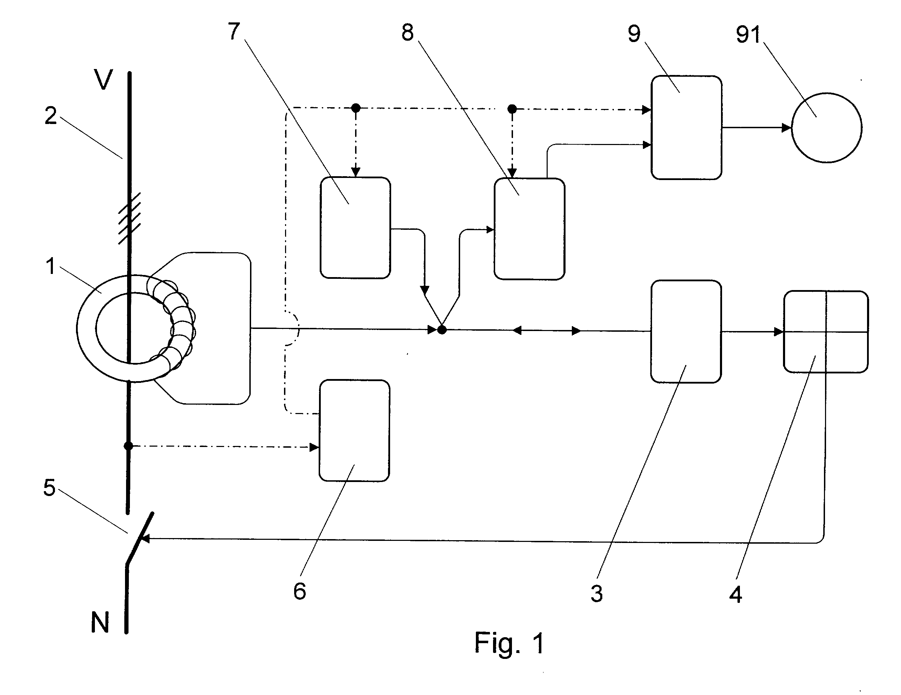

In allen Figuren bezeichnen gleiche Bezugszeichen auch gleichwirkende Teile. Der in den Fig.1 dargestellte F1-Schalter weist einen als Stromsensor wirkenden Summenstromwandler 1 auf, durch den die zur Stromversorgung eines Verbrauchers V notwendigen elektrischen Leiter 2 eines mehrphasigen Netzes N geführt sind. Der Summenstromwandler 1 wirkt mit einer nicht bezeichneten Sekundärwicklung auf einen Magnetauslöser 3, welcher seinerseits über ein Schaltschloss 4 auf eine die Leiter 2 unterbrechende Kontaktanordnung 5 wirkt. In ein Netzteil 6 wird Energie eingespeist, welche von den Leitern 2 abgenommen wird. Das Netzteil 6 versorgt einen steuerbaren, ebenfalls auf den Magnetauslöser 3 wirkenden Prüfsignalgenerator 7 sowie einen den Magnetauslöser 3 überwachenden Abhebedetektor 8 und eine Ausgangssignale des Abhebedetektors 8 aufnehmende Auswerte- und Meldeeinheit 9 mit einer nachgeschalteten Anzeige 91 mit Strom.

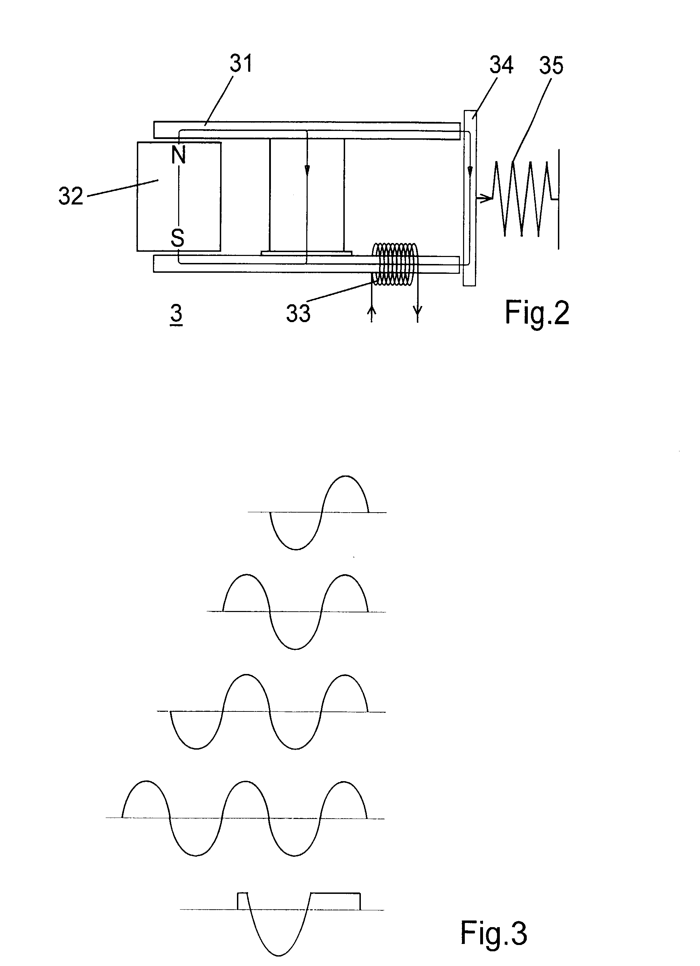

Aus Fig.2 ist ersichtlich, dass der Magnetauslöser 3 einen in ein U-förmiges Joch 31 einspeisenden Permanentmagneten 32, eine (vom Summenstromwandler 1 und dem Prüfsignalgenerator 7 gespeiste und) ebenfalls in das Joch 31 einspeisende Erregerspule 33 sowie einen unter der Wirkung einer vorgespannten Feder 35 stehenden und auf den Enden des Jochs 31 aufliegenden Anker 34 aufweist.

In der gezeichneten Lage ist der magnetische Kreis des Magnetauslösers 3 geschlossen und magnetischer Dauerfuss wird vom Permanentmagneten 32 in das Joch eingespeist und fliesst in der durch einen nach unten gerichteten Pfeil angezeigten Richtung durch den Anker 34. Beim Auftreten eines durch den Summenstromwandler 1 oder den Prüfsignalgenerator 7 in die Erregerspule 33 eingespeisten Stroms I schwächt der vom Magnetfeld dieses Stroms in den magnetischen Kreis eingespeiste magnetische Fluss den Fluss des Permanentmagneten 32 im Bereich des Ankers 34. Überschreitet der Strom einen vorgegebenen Ansprechstrom, der so gross ist, dass die Kraft der Feder 35 die vom geschwächten Fluss erzeugte Haltekraft gerade übertrifft, so hebt der Anker unter der Wirkung der vorgespannten Feder 35 vom Joch 31 ab. Wird der Strom 1 durch einen Fehlerstrom gebildet, so kann sich der Anker 34 weit vom Joch entfernen und dann über das Schaltschloss 4 die Kontaktanordnung 5 öffnen.

Wird der Strom I durch ein entsprechend Fig.3 ausgebildetes Prüfsignal gebildet, so wird der Anker 34 innerhalb einer kurzen Zeitspanne zweimal abgehoben und es wird zugleich verhindert, dass der Fl-Schalter anspricht. Das Prüfsignal weist zu diesem Zweck mindestens zwei Abschnitte auf, von der eine das zweimalige Abheben des Ankers 34 bewirkt. Dieser Abschnitt weist die Form einer negativen Wechselstrom-Halbwelle auf und hat eine mehrfach höhere Stromamplitude als ein das Abheben des Ankers beim Auftreten eines Fehlerstroms gerade noch bewirkender Ansprechstrom. Ein an diesen Abschnitt sich anschliessender zweiter Abschnitt bewirkt das Wiederanziehen des Ankers 34. Dieser Abschnitt weist umgekehrte Polarität wie der erste Abschnitt auf. Wie aus Fig.3 ersichtlich ist, umfasst das Prüfsignal mindestens eine Wechselstrom-Halbwelle sowie eine sich anschliessende weitere Wechselstrom-Halbwelle (Vollwelle) oder mehrere sich anschliessende weitere Wechselstrom-Halbwellen oder ein sich anschliessendes Gleichstromsignal mit einer gegenüber der Wechselstrom-Halbwelle umgekehrten Polarität. Lediglich aus Halbwellen aufgebaute Prüfsignale sind besonders geeignet, da sie in besonders einfacher Weise aus der Netzspannung erzeugt werden können.

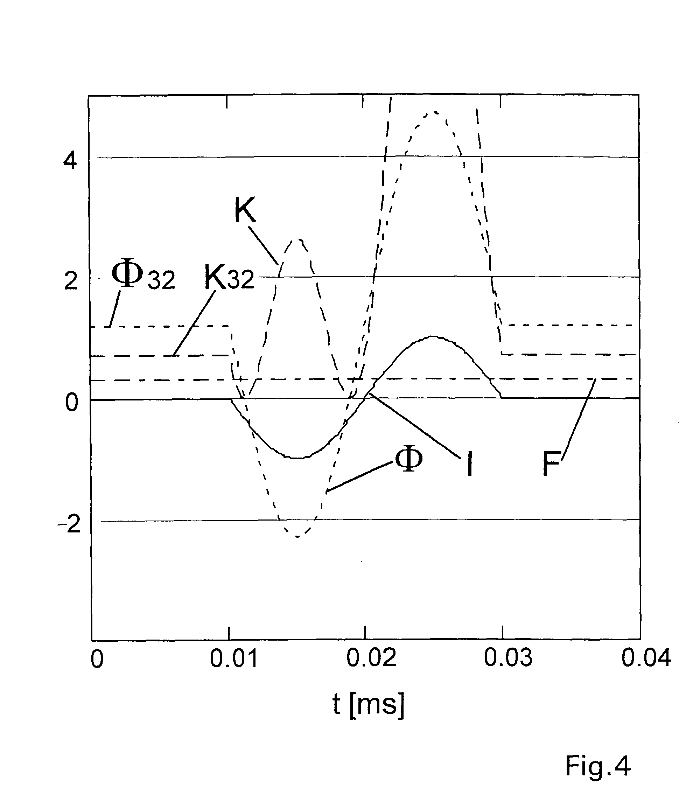

Wie aus dem Diagramm gemäss Fig.4 ersichtlich ist, ist vor dem Auftreten eines Prüfsignals die vom Magnetfluss Φ₃₂ des Permanentmagneten 32 hervorgerufene Kraft K₃₂ grösser als die von der Feder 35 erzeugte Kraft F. Der Anker 34 sitzt daher fest auf dem Joch 31 auf. Der von dem als Wechselstrom-Vollwelle ausgebildeten Prüfsignal über die Erregerspule 33 in den magnetischen Kreis des Magnetauslösers 3 eingespeiste Strom I erzeugt mit seiner negativen ersten Halbwelle einen entgegen dem magnetischen Fluss Φ₃₂ wirkenden Fluss, welcher mit dem Strommaximum seinen grössten negativen Wert erreicht. Dieser magnetische Fluss überlagert sich mit dem Magnetfluss Φ₃₂ zum Magnetfluss Φ und schwächt die Kraft K₃₂. Überwiegt die Kraft F der Feder 35, so hebt der Anker 34 ab. Im Nulldurchgang des Magnetflusses Φ wirkt die volle Kraft F der Feder 35 auf den Anker 34. Danach baut sich die Kraft K wieder auf und zieht den Anker 34 wieder an. Nach dem Durchschreiten des negativen Strommaximums der ersten Halbwelle verringert sich die Kraft K wieder. Kurz vor dem zweiten Nulldurchgang des Stroms I überwiegt die Kraft F der Feder 35 die vom magnetischen Fluss φ erzeugte Kraft. Der Anker 34 hebt nun ein zweites Mal ab. Nach dem zweiten Abheben des Ankers 34 wird in der umgekehrte Polarität aufweisenden zweiten Halbwelle der Anker 34 wieder mit grosser Kraft angezogen (gleichsinnige Magnetflüsse gemäss Fig.4).

Um die zuvor beschriebenen Wirkungen zu erreichen, sollte die Stromamplitude der ersten Halbwelle vorzugsweise mindestens 5-mal, typischerweise ca. 100-mal, grösser sein als ein durch einen Fehlerstrom verursachter (minimaler) Ansprechstrom des Magnetauslösers 3 . Die Dauer der Wechselstrom-Halbwelle beträgt vorzugsweise mehr als ca. 1 ms und weniger als ca. 100 ms.

Das Abheben des Ankers 34 wird mit dem Abhebedetektor 8 erfasst und das erfasste Signal an die Auswerte- und Meldeeinheit 9 weitergeleitet. Stellt der Abhebedetektor 8 fest, dass der Anker 34 nicht abgehoben hat, so wird dies mittels der Anzeige 91 kenntlich gemacht. Der Abhebedetektor 8 kann das Abheben des Ankers 34 akustisch (Mikrophon), optisch, mechanisch (Beschleunigungsaufnehmer) oder elektrisch feststellen. Da beim Abheben und und dem damit verbundenen Öffnen des magnetischen Kreises in der Erregerspule 33 eine Spannung induziert wird, kann diese Spannung in besonders einfacher Weise als Meldesignal verwendet werden. Der Abhebedetektor 8 ist dann in den Magnetauslöser 3 integriert und das von ihm erfasste Signal erscheint dann an zwei mit der Erregerspule 33 oder zumindest mit einem Abschnitt der Erregerspule verbundenen Anschlüssen des Magnetauslösers 3.

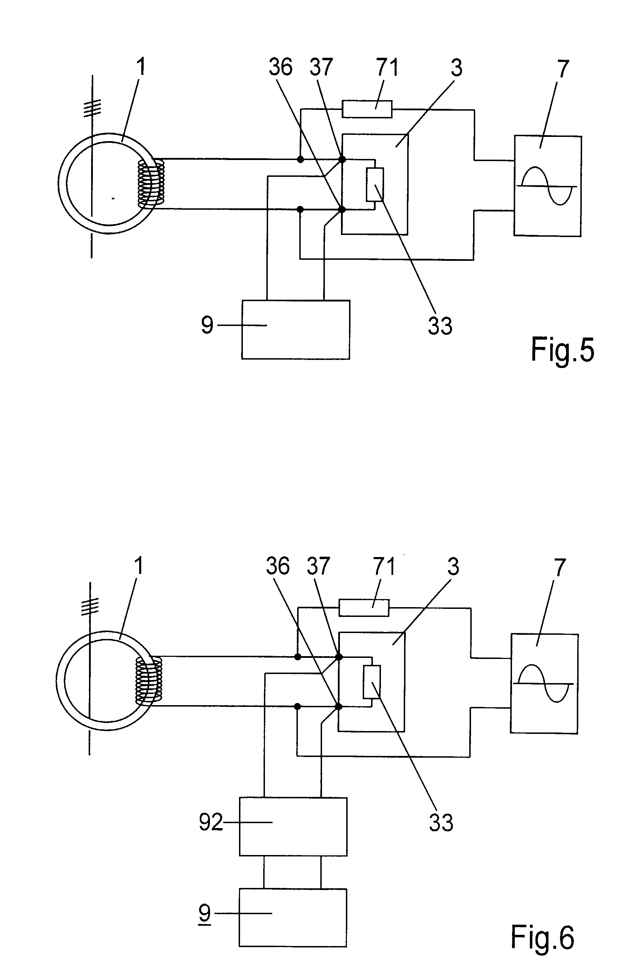

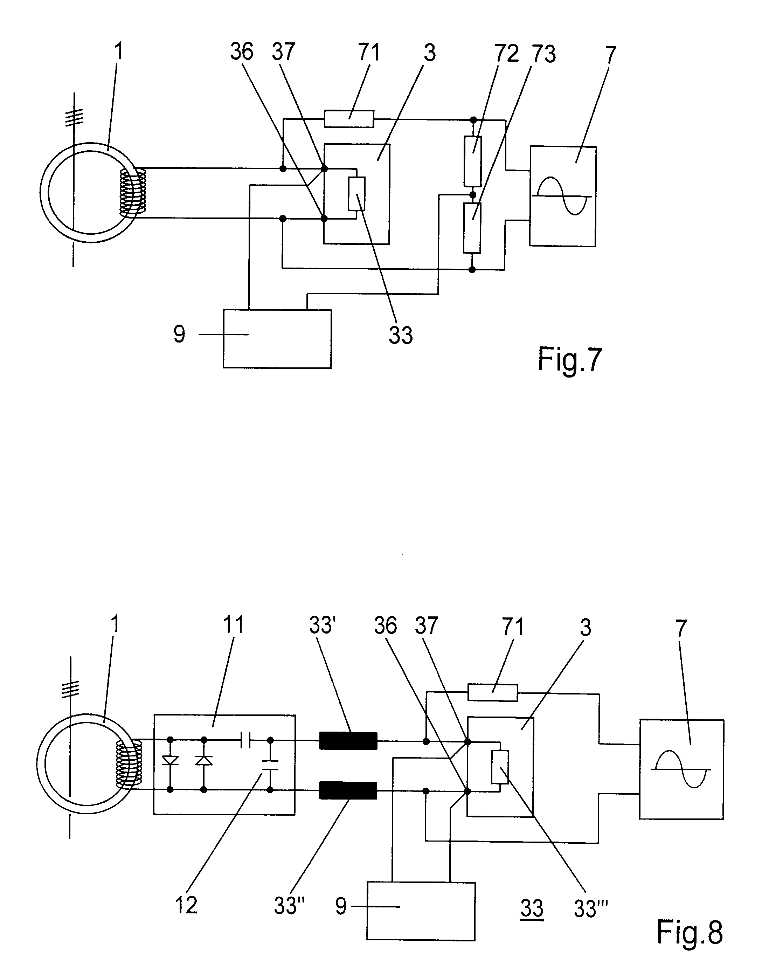

Dies ist aus den Blockschaltbildern gemäss den Figuren 5 bis 8 ersichtlich, in denen die beiden Anschlüsse des Magnetauslösers 3 mit den Bezugszeichen 36 und 37 bezeichnet sind. Hierbei ist bei allen in diesen Figuren dargestellten Ausführungsformen zwischen einem ersten Signalausgang des Prüfsignalgenerators 7 und dem Anschluss 37 eine hochohmige Impedanz 71 geschaltet und ist der zweite Signalausgang des Prüfsignalgenerators 7 direkt mit dem Anschluss 36 verbunden. Ferner ist eine Sekundärwicklung des Summenstromwandlers 1 mit den beiden Anschlüssen verbunden, bzw. wirkt bei der Ausführungsform gemäss Fig.8 über eine Beschaltung 11 auf die beiden Anschlüsse 36, 37. Die beiden Anschlüsse 36, 37 sind ferner mit der Auswerte-und Meldeeinheit 9 verbunden, welche gegebenfalls auch eine aus Fig.6 ersichtliche Filteranordnung 92 aufweist.

Bei allen Ausführungsformen wird das vom Prüfsignalgenerator 7 abgegebene Prüfsignal lediglich hochohmig in den Magnetauslöser 3 eingekoppelt. Durch die hochohmige Impedanz 71 wird so eine Beeinflussung des Magnetauslösers 3 durch den Prüfsignalgenerator 7 wesentlich herabgesetzt.

- Die aus Fig.6 ersichtliche, mit den beiden Anschlüssen 36, 37 des Magnetauslösers 3 verbundene Filteranordnung 92 der Auswerte- und Meldeeinheit 9 ist vorzugsweise als Hochpass ausgebildet und filtert aus dem an den Anschlüssen 36, 37 anstehenden und sich aus dem niederfrequenten Prüfsignal und dem hochfrequenten Abhebesignal zusammensetzenden Signal das niederfrequente Prüfsignal heraus. Im Unterschied zur Ausführungsform gemäss Fig.5 gelangt daher bei der Ausführungsform gemäss Fig.6 nur noch ein peakförmiges und daher besonders einfach verarbeitbares, hochfrequentes Abhebesignal in die Auswerte- und Meldeeinheit 9.

Anstelle der Filteranordnung 92 ist bei der Ausführungsform gemäss Fig.7 eine Brückenschaltung vorgesehen. Diese Brückenschaltung weist zwei vom Prüfsignalgenerator gespeiste Zweige auf, von denen der eine in Serie geschaltet zwei Impedanzen 72, 73 vorgebenener Grösse und der andere in Serie geschaltet die hochohmige Impedanz 71 und die zwischen den beiden Anschlüsse 36, 37 liegende Impedanz des Magnetauslösers 3 enthält. Zwischen dem Verbindungspunkt der beiden Impedanzen 72 und 73 und dem Anschluss 37, d.h. in eine Brückendiagonale, ist die Auswerte- und Meldeeinheit 9 geschaltet. Diese Brückenschaltung unterdrückt den durch den Prüfsignalgenerator 7 erzeugten Spannungsabfall des Prüfsignals über der Impedanz des Magnetauslösers 3 bzw. der Erregerspule 33 und führt so in besonders einfacher Weise zur Bildung eines rauschfreien und daher besonders leicht zu verarbeitenden Abhebesignals.

Die Impedanz 73 kann eine lineare oder nichtlineare Induktivität oder ein ohmscher Widerstand sein und dient der Nachbildung des Magnetauslösers 3. Mit Hilfe dieser Impedanz kann die Brückenschaltung in optimaler Weise abgeglichen werden.

Bei der für pulsierende Gleichfehlerströme vorgesehenen Ausführungsform gemäss Fig.8 ist zwischen dem als Fehlerstromsensor dienenden Summenstromwandler 1 und dem Magnetauslöser 3 die als Anpassungs- und Schutz-Netzwerk ausgeführte Beschaltung 11 angeordnet. Diese Beschaltung weist parallel zum Magnetauslöser 3 geschaltete Kondensatoren 12 auf. Zwischen jeden der beiden Anschlüssen 36, 37 und je einen der beiden Anschlüsse der Kondensatoren ist jeweils eine von zwei Impedanzen 33', 33" geschaltet. Durch diese Impedanzen wird ein Kurzschliessen und damit eine wesentliche Schwächung des Abhebesignals verhindert.

Es müssen nicht notwendigerweise zwei Impedanzen 33' und 33" vorgesehen sein. Ein Kurzschliessen und damit eine wesentliche Schwächung des Abhebesignals wird bereits dann erreicht, wenn lediglich eine der beiden Impedanzen 33', 33" vorhanden ist.

Mit Vorteil sind diese Impedanzen als Teil der Erregerspule 33 ausgeführt und steuern typischerweise zwischen 1 bis 20% der Impedanz der Erregerspule 33 bei. Die Erregerspule 33 weist dann Anzapfungen auf. Das der Erregung des Magnetauslösers 3 dienende Teil 33"' der Erregerspule 33 wird dann durch die Anzapfungen an die Anschlüsse 36, 37 geführt. Durch die induktiv ausgeführten Impedanzen 33', 33" werden hochfrequente Auslöseströme vom Magnetauslöser 3 und von der Auswerte- und Meldeeinheit 9 ferngehalten.

### Bezugszeichenliste

- 1: Summenstromwandler
- 2: Leiter
- 3: Magnetauslöser
- 4: Schaltschloss
- 5: Kontaktanordnung
- 6: Netzteil
- 7: Prüfsignalgenerator
- 8: Abhebedetektor
- 9: Auswerte- und Meldeeinheit
- 11: Beschaltung
- 12: Kondensatoren
- 31: Joch
- 32: Permanentmagnet
- 33: Erregerspule
- 34: Anker
- 35: Feder
- 36, 37: Anschlüsse
- 71, 72, 73: Impedanzen
- 91: Anzeige
- 92: Filteranordnung
- F: Kraft von Feder 35
- I: Strom von Prüfsignal
- K: Magnetkraft
- N: Netz
- V: Verbraucher
- Φ: Magnetfluss
- Φ₃₂: Magnetfluss des Permanentmagnet 32
- K₃₂: Magnetkraft des Permanentmagneten 32

## Patentansprüche

1. Verfahren zur Erhöhung der Zuverlässigkeit eines einen Magnetauslöser (3) mit einer Erregerspule (33), einem Permanentmagneten (32) und einem Anker (34) sowie einen auf den Magnetauslöser (3) wirkenden Fehlerstromsensor enthaltenden Fehlerstrom-Schutzschalters (Fl-Schalters),
(a) bei dem die Erregerspule (33) derart mit Prüfstrom beaufschlagt wird, dass im Magnetauslöser (3) ein Abheben und nachfolgendes Wiederanziehen des Ankers (34) des Magnetauslösers (3) erzielt wird,
(b) bei dem ein das Abheben des Ankers (34) detektierendes Signal erfasst und sein durch einen Fehler verursachtes Nichtauftreten gemeldet wird,
dadurch gekennzeichnet,
(c) dass der Prüfstrom von einem einzigen mindestens zwei Abschnitte aufweisenden Prüfsignal gebildet wird,
(d) dass im ersten Abschnitt der Prüfstrom die Form einer Wechselstrom-Halbwelle aufweist mit einer mehrfach höheren Stromamplitude als ein das Abheben des Ankers (34) beim Auftreten eines Fehlerstroms bewirkender Ansprechstrom,
(e) dass im ersten Abschnitt der Prüfstrom einen Magnetfluss erzeugt, welcher dem im Anker (34) geführten Magnetfluss (φ₃₂) des Permanentmagneten (32) entgegengesetzt gerichtet ist, und
(f) dass in dem an den ersten Abschnitt anschliessenden zweiten Abschnitt der Prüfstrom umgekehrte Polarität wie im ersten Abschnitt aufweist.

2. Verfahren nach Anspruch 1, dadurch gekennzeichnet, dass die Stromamplitude der Wechselstrom-Halbwelle mindestens 5-mal, vorzugsweise mindestens 50-mal, grösser ist als der durch den Fehlerstrom verursachte Ansprechstrom.

3. Verfahren nach einem der Ansprüche 1 oder 2, dadurch gekennzeichnet, dass die Dauer der Wechselstrom-Halbwelle mehr als ca. 1 ms und weniger als ca. 100 ms beträgt.

4. Verfahren nach einem der Ansprüche 1 bis 3, dadurch gekennzeichnet, dass der zweite Abschnitt des Prüfsignals die Form einer sich mit dem ersten Abschnitt zu einer Wechselstrom-Vollwelle ergänzenden Halbwelle aufweist.

5. Verfahren nach einem der Ansprüche 1 bis 3, dadurch gekennzeichnet, dass der zweite Abschnitt im wesentlichen vom einem Gleichstrom gebildet ist.

6. Fl-Schalter zur Durchführung des Verfahrens nach einem der Ansprüche 1 bis 5 mit einem das Prüfsignal erzeugenden und auf den Magnetauslöser (3) wirkenden Generator (7) und einer das Abheben des Ankers (34) erfassenden und mit dem Magnetauslöser (3) in Wirkverbindung stehenden Auswerte- und Meldeeinheit (9), dadurch gekennzeichnet, dass zwischen einem ersten Signalausgang des Prüfsignalgenerators (7) und einem ersten Anschluss (37) des Magnetauslösers (3) eine hochohmige Impedanz (71) geschaltet ist.

7. Fl-Schalter nach Anspruch 6, dadurch gekennzeichnet, dass zwischen dem ersten (37) und einem mit einem zweiten Signalausgang des Prüfsignalgenerators (7) verbundenen zweiten Anschluss (36) des Magnetauslösers (3) und der Auswerte- und Meldeeinheit (9) eine vorzugsweise als Hochpass ausgebildete Filteranordnung (92) geschaltet ist.

8. Fl-Schalter nach Anspruch 6, dadurch gekennzeichnet, dass der Prüfsignalgenerator (7) in die beiden Zweige einer Brückenschaltung speist, von denen der erste Zweig in Serie geschaltet zwei Impedanzen (72, 73) vorgebenener Grösse und der zweiter Zweig in Serie geschaltet die hochohmige Impedanz (71) und die zwischen dem ersten (37) und dem zweiten Anschluss (36) liegende Impedanz (33) des Magnetauslösers (3) enthält, und in deren zwischen dem Verbindungspunkt der beiden Impedanzen (72, 73) vorgegebener Grösse und dem ersten Anschluss (37) des Magnetauslösers (3) liegender Diagonale die Auswerte- und Meldeeinheit (9) geschaltet ist.

9. Fl-Schalter nach Anspruch 8, dadurch gekennzeichnet, dass die mit dem zweiten Anschluss (36) des Magnetauslösers verbundene der beiden Impedanzen (36, 37) vorgegebener Grösse als Nachbildung des Magnetauslösers ausgeführt ist.

10. Fl-Schalter nach einem der Ansprüche 6 bis 9 mit einem zwischen dem Fehlerstromsensor (1) und dem Magnetauslöser angeordneten Anpassungs- und Schutz-Netzwerk (9) mit parallel zum Magnetauslöser geschalteten Kondensatoren (12), dadurch gekennzeichnet, dass zwischen den ersten (37) und/oder den zweiten Anschluss (36) und die Kondensatoren (12) jeweils eine von zwei Impedanzen (33' 33") geschaltet ist.

11. Fl-Schalter nach Anspruch 10, dadurch gekennzeichnet, dass die erste und/oder die zweite der beiden Impedanzen (33', 33") Teil der Erregerwicklung (33) des Magnetauslösers (3) ist.
